# EUROPEAN PATENT APPLICATION

(11) **EP 0 574 807 A1**
(43) Date of publication of application: **22.12.1993**
(21) Application number: 93109187.0
(22) Date of filing: 08.06.1993
(51) Int. Cl.: C23C 16/40, C30B 25/02, C30B 29/30, C30B 29/32

(54) **Chemical vapor deposition of metal oxide films**

(30) Priority: 18.06.1992 US 900135
(71) Applicant: EASTMAN KODAK COMPANY, Rochester, New York 14650-2201 (US)
(72) Inventor: Wernberg, Alex Alex, c/o EASTMAN KODAK COMPANY, Rochester, New York 14650-2201 (US); Gysling, Henry James, c/o EASTMAN KODAK COMPANY, Rochester, New York 14650-2201 (US)
(74) Representative: Brandes, Jürgen, Dr. rer. nat.

(57) **Abstract**

Thin, uniform films of complex metal oxides are deposited by chemical vapor deposition onto a substrate by vaporizing a single source precursor solution, containing metal M' organometallic compound and a metal M'' organometallic compound, where metal M' is Li, Na, K, Ba, Mg, Ca, Sr, or Pb, and metal M'' is V, Nb, Ta, or Ti, and contacting the vapor with the substrate at a temperature sufficiently high to decompose the precursor and form an M'M'' metal oxide.

## Description

This invention relates to a method for depositing metal oxide films on a substrate. More particularly, this invention relates to the chemical vapor deposition of complex metal oxide films, such as lithium niobate, from a vaporized mixture of two compounds, each compound containing one of the individual metals of the resultant complex metal oxide.

Lithium niobate, LiNbO₃, is well known for its electrooptic, ferroelectric and piezoelectric properties, and is widely used in integrated and guided-wave optics applications, such as couplers, switches, modulators, deflectors and rf spectrum analyzers.

Although polycrystalline and single crystal LiNbO₃ have been prepared by a variety of standard solid state synthetic methods, relatively little work has been reported dealing with the fabrication of thin films of this material. Magnetron and rf sputtering and molecular beam epitaxy have been used to fabricate thin films of LiNbO₃. These techniques, however, require complicated and expensive high vacuum equipment. It is also difficult, using these processes, to maintain film uniformity over large areas. Further disadvantages are the low growth rates associated with these techniques as well as their difficulty in providing conformal coverage. Conformal coverage is the degree to which the deposition follows the contour of the substrate surface. Line of sight techniques such as sputtering typically exhibit poor conformal coverage.

In "Preparation of Crystalline LiNbO₃ Films with Preferred Orientation by Hydrolysis of Metal Alkoxides," Advanced Ceramic Materials, Vol. 3, No. 5, 1988, a process is disclosed for preparing LiNbO₃ thin films using single source reagents by a sol gel process utilizing hydrolysed metal alkoxides, such as, for example, an ethanol solution of lithium ethoxide and niobium ethoxide. It is difficult to obtain epitaxial films using sol-gel deposition techniques as it is not possible to control the crystallization rate using this process.

United States Patent No. 5,051,280 discloses a method for producing alkali metal niobates and tantalates which involves pyrolyzing the stoichiometric salt of an alkali metal and a niobium or tantalum complex of a bidentate or tridentate ligand. For example, the salt may be dissolved and then coated on a substrate, after which the coating is pyrolyzed at 400°C for 10 mins. It is difficult to obtain high quality films having monocrystallinity using such methods, due to the lack of control in the crystallization rate as well as the relatively large amount of organic material that is evolved during the processing of the coated precursor layer.

Chemical vapor deposition (CVD) is a technique capable of depositing films at high growth rates. To date there has been little work done on depositing complex metal oxide films such as LiNb0₃ by CVD.

One method for forming LiNbO₃ films by chemical vapor deposition is disclosed in United States Patent No. 3,911,176 to Curtis et. al., and in "The Growth of Thin Films of Lithium Niobate by Chemical Vapor Deposition," by B. Curtis and H. Brunner, Mat. Res. Bull. Vol. 10, pp. 515-520, 1975. Both of these references disclose vaporizing separate lithium and niobium compounds and bringing the resultant vapors in contact with a heated substrate in an oxidizing atmosphere. Preferred materials for producing the vapor precursor include lithium chelates of beta-diketonates and niobium alkoxides. One disadvantage to a process such as this, which utilizes separate sources for each metal precursor, is that it is difficult to make each precursor volatilize at the same rate. Consequently, because there is usually more of one metal than the other in the precursor vapor, it is difficult to achieve the desired 1:1 stoichiometry in the resultant LiNbO₃ film. In addition, when dual source precursors are involved, one of the metals may deposit preferentially, leading to an undesirable film composition. Further, the films deposited using the Curtis CVD method are initially black, and therefore not useful in many electro-optic applications which require high light transmittance, until they have first been annealed. Curtis teaches that these films should be annealed at a temperature of about 700° to 1000°C for 1 to 10 hours.

Thus, there continues to be a need for a chemical vapor deposition process that will produce lithium niobate, which produces monocrystalline films, having an epitaxial relationship to the substrate, and preferably which does not require a subsequent annealing operation. The same need holds true for other common complex metal oxides which exhibit useful electrooptic, ferroelectric and piezoelectric properties, in particular the vanadates, niobates, tantalates and titanates of alkali metals, alkaline earth metals, and lead.

In accordance with the present invention, it has been discovered that thin, uniform films of complex metal oxides of the form M'M''O₃ can be deposited by chemical vapor deposition onto a substrate by vaporizing a solution containing two compounds, each of which contains one of either M' or M''. By mixing the compounds in a stoichiometric ratio, and carefully controlling the vapor deposition process, relatively uniform and stoichiometric films are deposited. For example, by mixing and vaporizing a metal M' organometallic compound with a metal M'' organometallic compound, where one of either M' or M'' is Li, Na, K, Ba, Mg, Ca, Sr, or Pb, and the other of either M' or M'' is V, Nb, Ta, or Ti, and contacting the vapor with a substrate at a sufficiently high temperature, the vapor mixture will decompose and form an M'M'' metal oxide.

The method of the invention is particularly useful for forming complex metal oxides of the form M'M''O₃, such as LiNbO₃, LiTaO₃, BaTiO₃, KNbO₃, KTaO₃, PbTiO₃, SrTiO₃, and so forth. However, the method is not limited to oxides of this form. A particularly preferred embodiment of the method, used to form lithium niobate films, comprises dissolving a lithium organometallic compound, such as lithium butoxide, and a niobium organometallic compound, such as niobium ethoxide, into a solution, forming an aerosol of the solution vaporizing the aerosol, and passing the resulting vapors over a substrate heated to an appropriate temperature to decompose the precursor and form the desired oxide film. By mixing the metal ions in the vapor precursor solution in substantially the same stoichiometric ratio desired in the resultant film, at least a portion of the resultant film is of substantially uniform stoichiometry. Consequently, for a LiNbO₃ film, for example, a portion of the resultant film is essentially stoichiometric LiNbO₃. Using the method of the present invention, oxide films may be formed which are epitaxial with the substrate, transparent, and of generally higher quality than films produced using the techniques previously disclosed in the prior art.

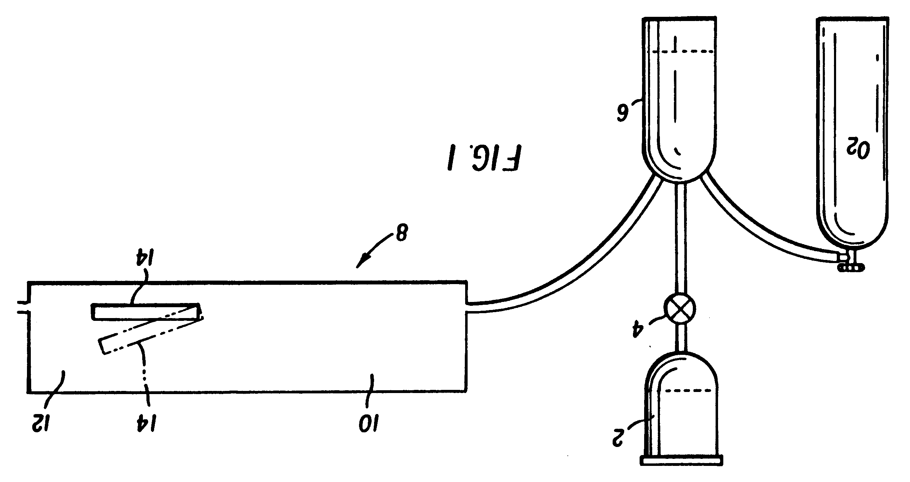

Fig. 1 shows a sectional view of an apparatus suitable for carrying out the chemical vapor deposition process in accordance with the invention.

In accordance with the present invention, complex metal oxide (i.e., oxides having more than one metal constituent) coatings are deposited by CVD using a vaporized solution containing dissolved organometallic compounds which contain the coating constituent metals in a relationship which produces films with useful properties. For example, in one preferred embodiment of the invention, organometallic compounds which contain Li and Nb are dissolved in an appropriate solvent and then vaporized and decomposed on a substrate to form LiNbO₃. Preferably, a solution of Li and Nb containing compounds, mixed in substantially a 1:1 molecular ratio of Li metal to Nb metal, is used to form the LiNbO₃. By substantially a 1:1 ratio, as used herein in the specification and claims, it is meant that the metal ratio of the single source precursor solution is substantially, but not necessarily exactly, the same metal ratio as the desired film. Consequently, the vapor will have substantially the same metal ratio as the precursor solution. Thus, for example, in the case of LiNbO₃ films, a suitable precursor solution of organometallic compounds might consist of, for example, an atomic ratio of about 48Li:52Nb or, more preferably, 50Li:50Nb. However, as will be discussed below, this amount of accuracy is not essential to forming stoichiometric LiNbO₃ films, and in some situations less stoichiometric solutions are sufficient for forming stoichiometric LiNbO₃ films.

It should also be noted that by "stoichiometric film", as used herein and in the claims, it is meant that the film has substantially the same metal ratio as the desired complex metal oxide. Thus, for example, a LiNbO₃ film having a uniform correct stoichiometry, as used herein and in the claims, has a substantially uniform and preferably a completely uniform composition of LiNbO₃, and does not, for example, contain substantial areas that are rich in Li or Nb metal content. However, in the present invention, due to relatively minor preferential decomposition and/or film formation of metal species, there are frequently significant portions of the resultant film which are only substantially stoichiometric. Thus, for example, a resultant LiNbO₃ film might consist of 45-55% Nb, and still be considered substantially stoichiometric, as used herein. Preferably, in the case of a LiNbO₃ film, the film is 100% LiNb0₃ throughout the entire deposited area.

The organometallic precursor compounds must be sufficiently soluble in an appropriate organic solvent and sufficiently volatile to allow vapor transport of the precursor compounds to the heated substrate after evaporation of the carrier solvent. Although a wide variety of such compounds have potential utility, reagents containing metal-oxygen bonds are especially preferred since they incorporate the basic framework of the desired solid state material and produce LiNbO₃ and other mixed oxide electrooptic ceramics at relatively low processing temperatures, with lower carbon contamination compared to other classes of precursor reagents (e.g., organometallics containing metal-carbon bonds). In addition, such precursors minimize or, ideally, eliminate the need for inclusion of oxygen in the processing atmosphere and therefore offer important safety advantages by reducing explosion hazards associated with mixtures of organic solvents and molecular oxygen.

Preferred compounds include, for example, metal ethoxides and butoxides. Thus, by dissolving a metal M' butoxide and a metal M'' ethoxide in an appropriate solvent, a solution is formed which contains the M' and M'' metals desired in the resultant oxide film. The solution is then atomized and/or vaporized to form a single source vapor precursor.

In some applications, it may be desirable to form the precursor solution by dissolving stoichiometric ratios of the solid components which contain the metal constituents in a suitable solvent. The resulting solution is then atomized or vaporized using conventional methods, such as, for example, an ultrasonic nebulizer. The single source vapor precursor is then transported to the substrate using any transport method conventionally utilized in CVD operations, such as, for example, by O₂ or an inert carrier gas. To form an oxide coating, the single source vapor precursor may be contacted with the substrate in an oxidizing atmosphere and at a temperature sufficient to decompose the precursor, leaving a film of the form M'M''0₃ on the substrate. Alternatively, if there is enough oxygen present in the single source vapor precursor, an oxidizing atmosphere may not be necessary, and the reaction may take place in an inert atmosphere.

One potential problem with chemical vapor deposition is the occasional tendency for one metal oxide to deposit preferentially relative to the other metal oxide. In the case of the method for forming LiNbO₃ in accordance with the present invention, for example, when horizontal reacting vessels (and substrate orientation) were employed, it was difficult to achieve a substantially uniform composition across the entire surface of the substrate. Thus, for example, the leading edge of the horizontal substrate would typically be lithium rich, while the trailing edge of the substrate would typically be lithium deficient. However, between these two edges, a region of film was present which comprised substantially uniform LiNbO₃. The composition of this region was sufficiently stoichiometric to be useful as an electrooptic, ferroelectric, or piezoelectric material.

Furthermore, by carefully controlling the deposition parameters, the size of the stoichiometric region can be increased. For example, by orienting the substrate vertically, rather than horizontally, the effect of having one Li rich edge and one Li deficient edge can be prevented, since the gas will impinge upon the entire length of the substrate at relatively the same time.

Further improvement on the consistency of film deposition may be achieved by utilizing a low pressure reactor. By lowering the pressure inside the reactor, the preferential decomposition of the precursor metal compounds can be minimized. Increasing the flow rate of precursor vapor into the reactant chamber will also help decrease the amount of preferential oxide formation on the substrate.

Finally, if one metal species reacts preferentially, the concentration of this species in the oxide film can be reduced by reducing its concentration in the initial precursor solution accordingly.

Suitable metal combinations for forming complex metal oxides in accordance with the invention are listed as follows:

| Metal M' | Metal M'' |
|---|---|
| Li, Na, K | V, Nb, Ta |
| Pb, Ba, Sr, Ca, Mg | Ti |

Although the present invention is particularly suited to forming oxides of the form M'M''0₃, complex metal oxides as used herein is meant to include any metal oxide in which there are two or more metal ions. Further, it should be noted that the above list of metals is given for example only, and is not meant to limit the invention.

The method of the invention is not limited to producing oxides of the form M'M''0₃, but is applicable to form any oxide having more than one metal in its composition, particularly those specifically listed above so long as a single source precursor compound can be formed having the desired metal ions and is sufficiently soluble and volatile to be operable.

The method can also be used to form oxides of the form M'M''M'''0ₓ, such as, for example, lead zirconate titanate (PZT). In such an application, three metals are incorporated into one single source precursor solution, then vaporized, etc., in accordance with the present invention to deposit the PbZrTi0₃ film by CVD.

A preferred CVD apparatus suitable for use in the method of the invention is illustrated in Fig. 1, although other conventional CVD apparatus can also be utilized. Referring to Fig. 1, a storage reservoir 2 is provided for storing the single source precursor solution, which is the M' and M'' organometallic compounds dissolved in a suitable solvent. The single source precursor solution is then dispensed from storage reservoir 2 by appropriately adjusting a valve 4, whereupon the solution is transported, in this case via gravity, to an atomization or nebulization chamber 6.

Alternatively, the solution may be placed directly into the atomization or nebulization chamber 6. The chamber 6 consists of any conventional means for converting the liquid single source precursor solution to a mist, such as, for example, an ultrasonic nebulizer. The solution is atomized in nebulization chamber 6, forming a single-source precursor mist. This atomized mist is then transported, using a suitable carrier gas, to a reactor 8, which has a low temperature zone 10 and a high temperature zone 12. The low temperature zone 10 is held at a high enough temperature to immediately volatilize the single-source precursor mist, forming a vapor from the single source precursor. The high temperature zone 12 is held at a temperature high enough to decompose the precursor, and allow the metal M' and metal M'' ions to react and form a complex metal oxide film on the substrate 14 located therein. The substrate 14 may be oriented horizontally or, preferably, is tilted toward the incoming precursor vapor, as illustrated in Figure 1.

Substrates suitable for use in this process ideally are stable up to about 1000°C. Most common substrates used in electro-optic technology can be used including single crystal and polycrystalline substrates. Suitable substrates include, for example, silicon, germanium, Group III-V semiconductor substrates such as gallium arsenide, platinum foil, yttrium aluminum garnet, spinel, sapphire, lithium niobate, lithium tantalate, magnesium oxide and strontium titanate.

The reaction may be carried out in a wide variety of apparatus and under varying reaction conditions. A carrier gas, which may or may not include oxygen, may be used or the reaction may take place at reduced pressure. Reaction temperatures, pressures and times may be varied.

The invention may be more easily comprehended by reference to the following specific examples, the first example illustrating the method of the invention.

### Example 1: Preparation of lithium niobate films from the separate precursors Li(O-t-C₄H₉) and Nb(O-C₂H₅)₅

A toluene solution containing 0.01 M each of Li(O-t-C₄H₉) and Nb(0-C₂H₅)₅ was prepared and the resulting solution was transferred to the ultrasonic nebulization chamber 6, as shown in Fig. 1, removed from the glove box and then connected to reactor 8. Chamber and reactor 8 were then purged with a carrier gas consisting of a mixture of 6% oxygen in argon, and reactor 8 heated to the desired operating temperature. Low temperature zone 10 of reactor 8 was heated to 360°C while high temperature zone 10, which contained a (1102) sapphire substrate 12 was heated to 506°C. On temperature equilibration of the reactor 8 and substrate 12, the solution was atomized in nebulization chamber 6 and transported into the reactor by the carrier gas flowing at 3.5 SLM. After deposition for thirty minutes, the atomization was discontinued and the reactor allowed to cool under the oxygen/argon flow. The thin film that formed on the sapphire substrate was not uniform. The substrate was diced into 1 cm sections and the resultant pieces analyzed for crystalline phases and elemental composition. The film that was formed closest to the entrance of the reactor was found to contain oriented lithium niobate as the only detectable crystalline phase. However, the ratio of lithium to niobium in this section of film was 6:4 as determined by inductively coupled plasma optical absorption spectroscopy (ICP). The only phase detected in the film obtained in the second section of substrate was a polycrystalline lithium niobate phase. ICP analysis indicated that the film in this portion was lithium deficient, the ratio of lithium to niobium being 3.5:6.5. Films formed farther along on the substrate contained decreasing ratios of lithium to niobium with no crystalline phases being detected by XRD. Films formed on the substrate farthest away from the entrance of the reactor contained niobium only. However, in between the Li-rich and Li-deficient portion was a portion LiNbO₃ having a substantially uniform and correct stoichiometry. This portion would be useful as an electro-optic material. This useful portion could be made larger by varying certain deposition parameters, such as, for example, using a vertical reactor under a low pressure, and so forth.

## Claims

1. A method for depositing a complex metal oxide film on a substrate, which comprises:
dissolving a metal M' organometallic compound and a metal M'' organometallic compound in a solution to form a single source precursor, wherein one of either M' or M'' is Li, Na, K, Mg, Ca, Sr, Ba, or Pb, and the other of either M' or M'' is V, Nb, Ta, or Ti,
vaporizing said single source precursor, and
contacting said substrate with the vapor of said single source precursor at a temperature sufficient to decompose said precursor and deposit said complex metal oxide on said substrate.

2. A method according to claim 1, wherein said substrate is contacted with said vapor in an oxidizing atmosphere.

3. A method according to claim 1, wherein a portion of said deposited oxide film has a substantially uniform composition on said substrate.

4. A method according to claim 1, wherein said metal M' organometallic compound and said metal M'' organometallic compound are dissolved in an equimolar ratio.

5. A method according to claim 1, wherein a portion of said oxide film has a substantially uniform and stoichiometric composition.

6. A method according to claim 1, wherein the vapor of said precursor contains a third metal compound.

7. A method for depositing an oxide film of LiNbO₃ on a substrate, which comprises:
dissolving a lithium organometallic compound and a niobium organometallic compound in a suitable solvent to form a single source precursor solution,
vaporizing said single source precursor, and
contacting said substrate with the vapor of said single source precursor at a temperature sufficient to decompose said precursor and form a film of LiNbO₃ on said substrate.

8. A method according to claim 7, wherein said substrate is contacted with said vapor in an oxidizing atmosphere.

9. A method according to claim 7, wherein a portion of said oxide film has a substantially uniform composition.

10. A method according to claim 7, wherein a portion of said oxide film has a substantially uniform and correct stoichiometry.

11. A method according to claim 7, wherein said lithium organometallic compound and said niobium organometallic compound are dissolved in an equimolar ratio.
